# EUROPEAN PATENT APPLICATION

(11) **EP 4 545 988 A1**
(43) Date of publication of application: **30.04.2025**
(21) Application number: 22945116.6
(22) Date of filing: 22.11.2022
(51) Int. Cl.: G01R 31/367, G01R 31/396, G01R 31/36, G01R 31/374, G01R 31/382

(54) **BATTERY LIFE PREDICTION DEVICE AND METHOD**

(30) Priority: 23.06.2022 KR 20220077031
(71) Applicant: Hyosung Heavy Industries Corporation, Seoul 04144 (KR)
(72) Inventor: KIM, Byoung Choul, Incheon 21680 (KR); PARK, Sang Hui, Anyang-si, Gyeonggi-do 14019 (KR); JUNG, Sung Chul, Yongin-si, Gyeonggi-do 16844 (KR)
(74) Representative: Viering, Jentschura & Partner mbB Patent- und Rechtsanwälte
(86) International application number: PCT/KR2022/018532
(87) International publication number: WO 2023/249172

(57) **Abstract**

The present invention relates to an apparatus for predicting battery lifetime that may predict battery time more accurately by removing errors due to a characteristic of recovering temporary capacity happening intermittently from charge/discharge test data of a battery and a method thereof.

The apparatus for predicting battery lifetime in accordance with the present invention comprises: a capacity recovery section-determining unit for determining a temporary capacity recovery section by analyzing charge/discharge test data of a battery; a trend analysis unit for creating alternative data based on test data before and after the temporary capacity recovery section determined by the capacity recovery section-determining unit, and analyzing trend of the test data by reflecting the alternative data; and a lifetime predicting unit for predicting lifetime of the battery based on data outputted from the trend analysis unit.

## Description

### FIELD OF THE INVENTION

The present invention relates to an apparatus for predicting battery lifetime and a method thereof, and more particularly, to the apparatus for predicting the battery lifetime based on a battery charge/discharge test and the method thereof.

### BACKGROUND OF THE INVENTION

In general, a battery, which has a composition where an anode and a cathode are placed opposing each other in an electrolyte, and supplies power by generating direct current (DC) power by chemical reactions, is used in a variety of fields such as power systems.

It is common that a battery has a discharging function for converting chemical energy into electrical energy and providing the energy, and a charging function for storing chemical energy by an external power source. As such, the batteries that can be recharged and discharged repeatedly are referred to as secondary batteries.

During the process of the batteries repeatedly being recharged and discharged, the lifetime of the batteries is diminished. Studies to predict such lifetime have been continued.

For an example, Korean Patent Laid-Open Publication No. 10-2019-7037712 proposed a method of improving battery performance, and extending battery lifetime by operating an apparatus with a pattern of preventing battery voltage from falling below threshold value, and reducing a possibility for the battery voltage to drop below the threshold value, including a battery recovery period.

However, even in this case, it has a big disadvantage of having large errors in predicting battery lifetime because it does not properly consider a temporary capacity recovery characteristic of the battery happening intermittently.

### DETAILED EXPLANATION OF THE INVENTION

### OBJECTS OF THE INVENTION

An object of the present invention is to provide an apparatus for determining a temporary capacity recovery section in battery charge/discharge test data, and replacing or calibrating it to remove a temporary capacity recovery characteristic that happens intermittently from the battery charge/discharge test data, and a method thereof.

The other object of the present invention is to provide an apparatus for predicting battery lifetime more accurately by removing errors due to a temporary capacity recovery characteristic that happens intermittently from battery charge/discharge test data, and a method thereof.

### MEANS OF SOLVING THE PROBLEM

An apparatus for predicting battery lifetime in accordance with one example embodiment of the present invention may comprise: a capacity recovery section-determining unit for determining a temporary capacity recovery section by analyzing charge/discharge test data of a battery; a trend analysis unit for creating alternative data based on test data before and after the temporary capacity recovery section in the capacity recovery section-determining unit, and analyzing trend of the test data by reflecting the alternative data; and a lifetime predicting unit for predicting lifetime of the battery based on data outputted from the trend analysis unit.

Herein, the capacity recovery section-determining unit may determine a section where the charge/discharge test data of the battery is changed by at least a certain value as a capacity recovery section.

In addition, the capacity recovery section-determining unit may determine a section where change of the charge/discharge test data of the battery shows increment by at least 0.2% compared to the previous capacity as a temporary capacity recovery section.

Meanwhile, a method of the trend analysis unit creating alternative data based on the test data before and after the temporary capacity recovery section may be one of methods of replacing the section with a previous trend line of the temporary capacity recovery section, replacing by applying a particle filter, and pulling and putting together a section after the temporary capacity recovery section except the temporary capacity recovery section.

Furthermore, the method of the trend analysis unit analyzing trend of the test data may be one of moving average depending on increase of charge/discharge cycles, moving average on differential data depending on increase of charge/discharge cycles, or moving average on log data depending on increase of charge/discharge cycles.

Meanwhile, the lifetime predicting unit may predict the lifetime of the battery based on a semi-empirical aging model.

A method of predicting battery lifetime in accordance with one example embodiment of the present invention may comprise steps of: a capacity recovery section-determining unit determining a temporary capacity recovery section by analyzing charge/discharge test data of a battery; a trend analysis unit creating alternative data based on test data before and after the temporary capacity recovery section, and analyzing trend of the charge/discharge test data by reflecting the alternative data; and a lifetime predicting unit predicting lifetime of the battery based on data outputted from the trend analysis unit.

Herein, the capacity recovery section-determining unit may determine a section where the charge/discharge test data of the battery is changed by at least a certain value as a capacity recovery section.

Moreover, the capacity recovery section-determining unit may determine a section where the charge/discharge test data of the battery is changed by at least a certain value as a capacity recovery section.

Meanwhile, a method of the trend analysis unit creating alternative data based on test data before and after the temporary capacity recovery section may be one of methods of replacing the section with a previous trend line of the temporary capacity recovery section, replacing by applying a particle filter, and pulling and putting together a section after the temporary capacity recovery section except the temporary capacity recovery section.

### EFFECTS OF THE INVENTION

An apparatus for predicting battery lifetime and a method thereof in accordance with the present invention have an advantage of determining a temporary capacity recovery section in battery charge/discharge test data, and replacing or calibrating it to remove a temporary capacity recovery characteristic that happens intermittently from the battery charge/discharge test data.

Moreover, the apparatus for predicting battery lifetime and a method thereof in accordance with the present invention have an advantage of predicting battery lifetime more accurately by removing errors due to a temporary capacity recovery characteristic that happens intermittently from battery charge/discharge test data.

### BRIEF DESCRIPTION OF THE DRAWINGS

Fig. 1 is a drawing illustrating an apparatus for predicting battery lifetime in accordance with one example embodiment of the present invention.
Fig. 2 is a graph for explaining operation of the capacity recovery section-determining unit in Fig. 1.
Fig. 3 is a graph for explaining operation of the lifetime predicting unit in Fig. 1.
Fig. 4 is a graph for explaining another operation of the lifetime predicting unit in Fig. 1.
Fig. 5 is an operational flow chart showing a method of predicting battery lifetime in accordance with one example embodiment of the present invention.

### DETAILED DESCRIPTION OF THE PREFERRED EMBODIMENTS

Detailed examples of embodiments to implement the present invention are explained by referring to attached drawings.

The present invention may have various changes, and several examples of embodiments, and therefore, it is intended that specific example embodiments are exemplified in drawings, and detailed explanations are given more specifically. This is not intended to limit the present invention to specific examples of embodiments, and it may be understood that this includes all changes, equivalents, and substitutes in the spirit and technical scope of the present invention.

Below is detailed explanation on an apparatus for predicting battery lifetime and a method thereof in accordance with the present invention by referring to the attached drawings.

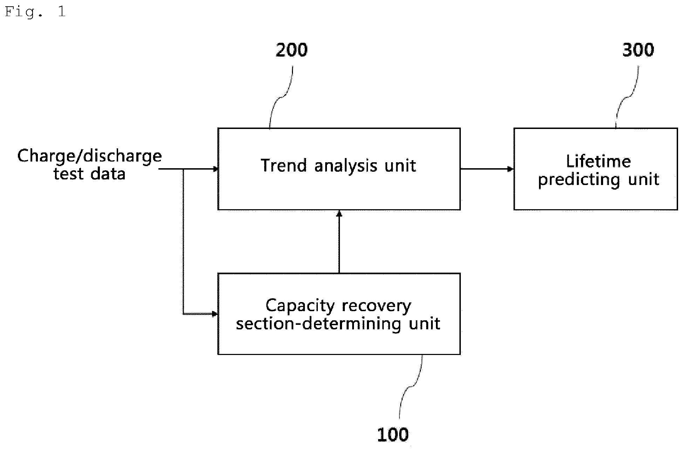

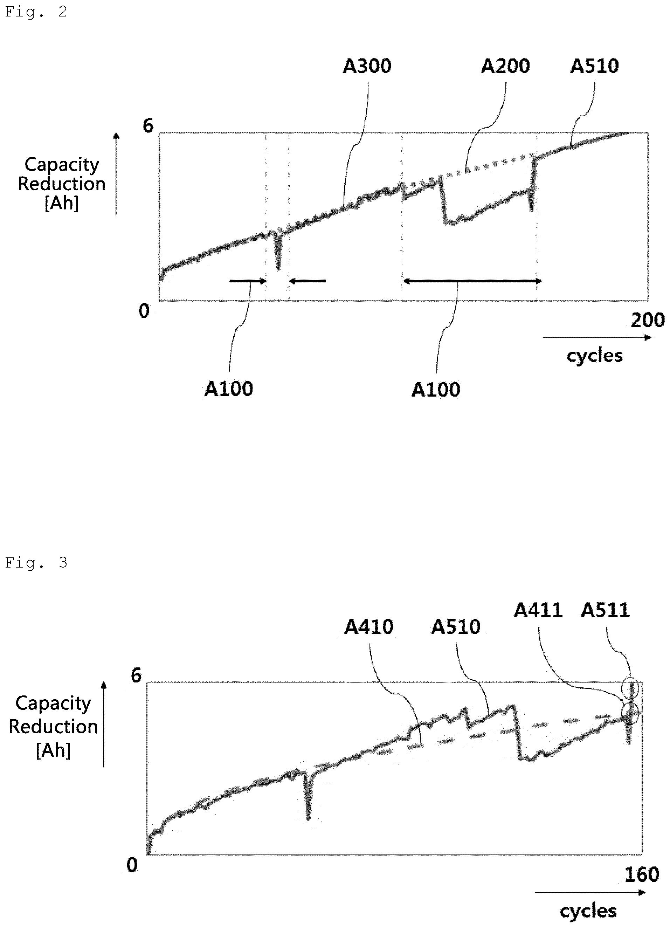

Fig. 1 is a drawing illustrating an apparatus for predicting battery lifetime in accordance with one example embodiment of the present invention, and Figs. 2 to 4 are detailed graphs for explaining Fig. 1 more specifically.

By referring to Figs. 1 to 4, the apparatus for predicting battery lifetime in accordance with one example embodiment of the present invention is explained.

First, by referring to Fig. 1, the apparatus for predicting battery lifetime in accordance with one example embodiment of the present invention comprises: a capacity recovery section-determining unit 100 for determining a temporary capacity recovery section by analyzing charge/discharge test data of a battery; a trend analysis unit 200 for creating alternative data based on test data before and after the temporary capacity recovery section determined by the capacity recovery section-determining unit 100, and analyzing trend of the test data by reflecting the alternative data; and lifetime predicting unit 300 for predicting lifetime of the battery based on data outputted from the trend analysis unit 200.

Generally, data is accumulated by performing battery charge/discharge tests to predict battery lifetime, and the more data accumulated, the more accurate prediction can be made. However, this method has disadvantages like it may take a longer time to predict lifetime, and battery lifetime may rather be reduced due to charge/discharge cycles for testing.

Meanwhile, battery lifetime prediction may be performed based on short-term data, and at this time, there are many cases where the temporary capacity recovery characteristic of the battery happens intermittently. If the battery lifetime is predicted based on the charge/discharge test data where the temporary capacity recovery characteristic is included, large errors in lifetime prediction may be caused.

Therefore, to predict the battery lifetime for a short time in consideration of the temporary capacity recovery characteristic, the present invention has the temporary capacity recovery section-determining unit 200 to analyze the charge/discharge test data, and determine a section where the temporary capacity recovery characteristic happens. Based on test data before and after the section where the temporary capacity recovery characteristic happens, alternative data is created, and based on this, the lifetime predicting unit 300 predicts battery lifetime.

Through this, the apparatus for predicting the battery lifetime in accordance with the present invention has an advantage of detecting a temporary capacity recovery section of the battery in consideration of the temporary capacity recovery characteristic of the battery, and thus increasing the accuracy of the battery lifetime by reflecting the section, and performing the battery lifetime prediction.

Meanwhile, the lifetime predicting unit 300 in accordance with the present invention may predict the battery lifetime based on a semi-empirical aging model, which is a model that may predict the battery lifetime based on some of the charge/discharge data.

Fig. 2 is a graph for explaining operation of the capacity recovery section-determining unit 100 in Fig. 1.

As can be seen in Fig. 2, the capacity recovery section-determining unit 100 in accordance with the present invention determines a temporary capacity recovery section, and then the trend analysis unit 200 analyzes a data trend based on the result of the determination of the capacity recovery section-determining unit 100.

In other words, the capacity recovery section-determining unit 100 determines a capacity recovery section A100 included in charge/discharge test data A510, and the trend analysis unit 200 creates alternative data based on trend of data before and after the section A100 determined as the temporary capacity recovery section by the capacity recovery section-determining unit 100, and analyzes trend of the test data by reflecting the alternative data.

At the time, the capacity recovery section-determining unit 100 in accordance with the present invention determines, as a capacity recovery section, a section where test data is changed by at least a certain value depending on the increased charge/discharge cycle. For example, a section where change of the test data shows increment by at least 0.2% compared to the previous capacity may be recognized as a temporary capacity recovery section.

In addition, a method of the trend analysis unit 200 creating alternative data for the section A100 determined as a temporary capacity recovery section may be one of methods of replacing the section with a trend line for 50 cycles before the temporary capacity recovery section, replacing by applying a particle filter, and pulling and putting together a section after the temporary capacity recovery section except the temporary capacity recovery section.

In other words, the trend analysis unit 200 in accordance with the present invention creates alternative data based on test data before and after the temporary capacity recovery section, and replaces the section, and then analyzes trend of the test data.

At the time, the trend analysis may be carried out under any of the methods of moving average depending on increase of charge/discharge cycles, moving average on differential data depending on increase of charge/discharge cycles, and moving average on log data depending on increase of charge/discharge cycles, etc.

When the trend of the charge/discharge test data A510 is analyzed, and there is a little test data, the data may be analyzed in the method of moving average, or in the method of moving average of differential data by using slope of the charge/discharge test data A510.

Besides, since the charge/discharge test data A510 takes the form of a log graph in the long term, the data may be analyzed with the moving average on the log data where logs are applied to the charge/discharge test data A510.

As such, the present invention may determine a temporary capacity recovery section in battery charge/discharge test data, and replace or calibrate the section to remove a temporary capacity recovery characteristic that happens intermittently from the battery charge/discharge test data.

Fig. 3 is a graph for explaining operation in case where the lifetime predicting unit 300 in Fig. 1 applies the charge/discharge test data A510 as it is. As explained above, in accordance with the present invention, the lifetime prediction unit 400 predicts battery lifetime based on a semi-empirical aging model.

Fig. 3 illustrates that the charge/discharge test data A510 is applied as it is to input of the lifetime prediction unit 400. In this case, regarding lifetime prediction data A410 based on the charge/discharge test data, it may be seen that lifetime prediction value affected by intermittent temporary recovery characteristic generally goes down because the temporary capacity recovery characteristic from the charge/discharge test data A510 is not considered.

In other words, while capacity is reduced by approximately 6[Ah] at a point A511 of a section where the capacity recovery characteristic does not happen from the charge/discharge test data, it may be known that lifetime predicted by the lifetime predicting unit 300 is approximately 5[Ah], which is less accurate.

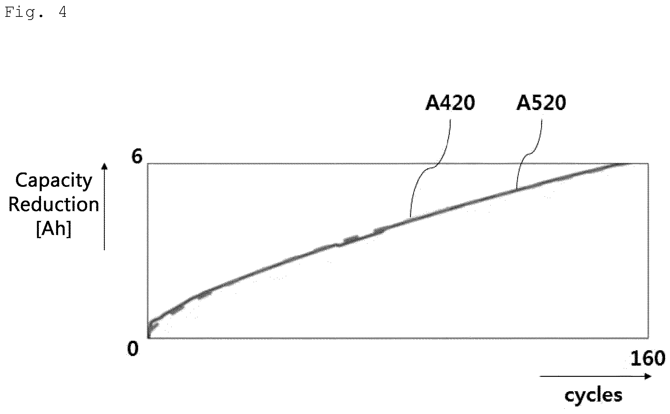

Next, Fig. 4 is a graph for explaining operation in case where the lifetime predicting unit 300 in Fig. 1 considers the temporary capacity recovery characteristic from the charge/discharge test data A510. It illustrates that the trend analysis unit 200 predicts battery lifetime by reflecting alternative data A520 from which the temporary capacity recovery characteristic is removed.

As can be seen in Fig. 4, looking at a result of predicting the battery lifetime, lifetime prediction data A420 predicted based on alternative data A520 from which the temporary capacity recovery characteristic is removed can be known to have very high prediction accuracy.

Like this, the present invention may predict battery lifetime more accurately by removing errors due to a characteristic of recovering temporary capacity happening intermittently from charge/discharge test data.

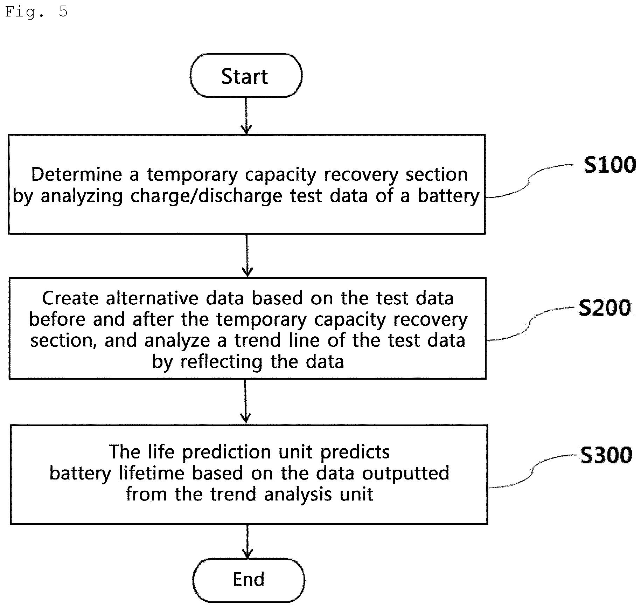

Fig. 5 is an operational flow chart showing a method of predicting battery lifetime in accordance with one example embodiment of the present invention.

As can be seen in Fig. 5, the method of predicting battery lifetime comprises steps of: a capacity recovery section-determining unit 100 determining a temporary capacity recovery section by analyzing charge/discharge test data of a battery S100; a trend analysis unit 200 creating alternative data based on test data before and after the temporary capacity recovery section in the capacity recovery section-determining unit 100, and analyzing trend of the test data by reflecting the alternative data S200; and a lifetime predicting unit 300 predicting lifetime of the battery based on data outputted from the trend analysis unit 200 S300.

Herein, the capacity recovery section-determining unit 100 may determine a section where the charge/discharge test data of the battery is changed by at least a certain value depending on the increase of charge/discharge cycles as a capacity recovery section, and for an example, a section where change of the charge/discharge test data of the battery shows increment by at least 0.2% compared to the previous capacity may be recognized as a temporary capacity recovery section.

In addition, a method of the trend analysis unit 200 creating alternative data for a section A100 determined as the temporary capacity recovery section may be one of methods of replacing the section with a trend line for 50 cycles before the temporary capacity recovery section, replacing by applying a particle filter, or pulling and putting together a section after the temporary capacity recovery section except the temporary capacity recovery section.

In other words, the trend analysis unit 200 in accordance with the present invention creates alternative data based on test data and replaces the section before and after the temporary capacity recovery section, and then analyzes trend of the test data.

At the time, trend analysis is possible in any of the methods of moving average depending on increase of charge/discharge cycles, moving average on differential data depending on increase of charge/discharge cycles, or moving average on log data depending on increase of charge/discharge cycles, and the detailed methods, which have been explained above, are omitted.

Meanwhile, the lifetime predicting unit 300 may predict the lifetime of the battery based on a semi-empirical aging model that may predict lifetime of the battery based on some charge/discharge data.

As seen above, the apparatus for predicting battery lifetime and the method thereof in accordance with the present invention have an advantage of determining a temporary capacity recovery section in battery charge/discharge test data, and replacing or calibrating it to remove a temporary capacity recovery characteristic that happens intermittently from the battery charge/discharge test data. In addition, more accurate battery lifetime prediction is possible by removing errors due to the temporary capacity recovery characteristic that happens intermittently from battery charge/discharge test data.

The above-mentioned example embodiments include one or more examples of embodiments. Of course, it may be recognized that they cannot describe all possible combinations of components or methods for the purpose of explaining aforementioned example embodiments but they may be added or replaced with a lot of additional combinations of various example embodiments by those skilled in the art. Accordingly, the explained example embodiments include all alternatives, modifications, and alternations within the intention and scope of what is claimed as attached below.

### Industrial Availability

The present invention relates to an apparatus for predicting battery lifetime and a method thereof, and they are available in a field of battery.

## Claims

1. A battery lifetime predicting apparatus, comprising:
a capacity recovery section-determining unit for determining a temporary capacity recovery section by analyzing charge/discharge test data of a battery;
a trend analysis unit for creating alternative data based on test data before and after the temporary capacity recovery section determined by the capacity recovery section-determining unit, and analyzing trend of the test data by reflecting the alternative data; and
a lifetime predicting unit for predicting lifetime of the battery based on data outputted from the trend analysis unit.

2. The apparatus of Claim 1, wherein the capacity recovery section-determining unit determines a section where the charge/discharge test data of the battery is changed by at least a certain value as a capacity recovery section.

3. The apparatus of Claim 2, wherein the capacity recovery section-determining unit determines, as a temporary capacity recovery section, a section where change of the charge/discharge test data of the battery shows increment by at least 0.2% compared to the previous capacity.

4. The apparatus of Claim 1, wherein a method of the trend analysis unit creating alternative data based on the test data before and after the temporary capacity recovery section is one of methods of replacing the section with a previous trend line of the temporary capacity recovery section, replacing by applying a particle filter, and pulling and putting together a section after the temporary capacity recovery section except the temporary capacity recovery section.

5. The apparatus of Claim 4, wherein the method of the trend analysis unit analyzing trend of the test data is one of methods of moving average depending on increase of charge/discharge cycles, moving average on differential data depending on increase of charge/discharge cycles, or moving average on log data depending on increase of charge/discharge cycles.

6. The apparatus of Claim 1, wherein the lifetime predicting unit predicts the lifetime of the battery based on a semi-empirical aging model.

7. A method of predicting battery lifetime, comprising steps of:
a capacity recovery section-determining unit determining a temporary capacity recovery section by analyzing charge/discharge test data of a battery;
a trend analysis unit creating alternative data based on test data before and after the temporary capacity recovery section, and analyzing trend of the test data by reflecting the alternative data; and
a lifetime predicting unit predicting lifetime of the battery based on data outputted from the trend analysis unit.

8. The method of Claim 7, wherein the capacity recovery section-determining unit determines a section where the charge/discharge test data of the battery is changed by at least a certain value as a capacity recovery section.

9. The method of Claim 8, wherein the capacity recovery section-determining unit determines a section where change of the charge/discharge test data of the battery shows increment by at least 0.2% compared to the previous capacity as a temporary capacity recovery section.

10. The method of Claim 7, wherein a method of the trend analysis unit creating alternative data based on the test data before and after the temporary capacity recovery section is one of methods of replacing the section with a previous trend line of the temporary capacity recovery section, replacing by applying a particle filter, and pulling and putting together a section after the temporary capacity recovery section except the temporary capacity recovery section.
